# EUROPÄISCHE PATENTANMELDUNG

(11) **EP 4 254 800 A2**
(43) Veröffentlichungstag der Anmeldung: **04.10.2023**
(21) Anmeldenummer: 23157494.8
(22) Anmeldetag: 20.02.2023
(51) Int. Cl.: H03K 17/96

(54) **BEDIENVORRICHTUNG FÜR EIN HAUSHALTSGERÄT UND HAUSHALTSGERÄT MIT EINER BEDIENVORRICHTUNG**

(30) Priorität: 30.03.2022 BE 202205230
(71) Anmelder: Miele & Cie. KG, 33332 Gütersloh (DE)
(72) Erfinder: Banmann, Johann, 33334 Gütersloh (DE); Hunger, Helmut, 33335 Gütersloh (DE); Bros, Sebastian, 33611 Bielefeld (DE); Kupfer, Matthias, 33649 Bielefeld (DE)

(57) **Zusammenfassung**

Die Erfindung betrifft eine Bedienvorrichtung (4) für ein Haushaltsgerät (2), umfassend ein Gehäuse (6), eine das Gehäuse (6) nach Außen abdeckende Schalterblende (8), eine in dem Gehäuse (6) angeordnete Leiterplatte (10), mindestens eine berührungsempfindliche Bedieneinheit (12) mit jeweils einer auf einer Außenseite der Schalterblende (8) angeordneten Bedienfläche (14) und mindestens einer auf der Leiterplatte (10) angeordneten und der jeweiligen Bedienfläche (14) zugeordneten Schaltelektronik (16), wobei die jeweils zueinander korrespondierende Bedienfläche (14) und Schaltelektronik (16) mittels eines Kopplungselements (18) der jeweiligen Bedieneinheit (12) miteinander elektrisch leitend verbunden sind, und mindestens eine auf der Leiterplatte (10) angeordnete und der jeweiligen Bedienfläche (14) funktional zugeordnete Lichtquelle (20) zur bedarfsweisen Hinterleuchtung dieser Bedienfläche (14), dadurch gekennzeichnet, dass das Kopplungselement (18) gleichzeitig als ein Abschirmelement zur Abschirmung von mittels der Lichtquelle (20) erzeugtem sichtbaren Licht ausgebildet und derart angeordnet ist, dass von der Lichtquelle (20) emittiertes sichtbares Licht im Wesentlichen lediglich die Bedienfläche (14) hinterleuchtet, der diese Lichtquelle (20) zugeordnet ist.

Ferner betrifft die Erfindung ein Haushaltsgerät (2) mit einer Bedienvorrichtung (4).

## Beschreibung

Die Erfindung betrifft eine Bedienvorrichtung für ein Haushaltsgerät der im Oberbegriff des Patentanspruchs 1 genannten Art und ein Haushaltsgerät mit einer Bedienvorrichtung.

Derartige Bedienvorrichtungen für Haushaltsgeräte und Haushaltsgeräte mit Bedienvorrichtungen sind aus dem Stand der Technik bereits in einer Vielzahl von Ausführungsformen vorbekannt. Die bekannten Bedienvorrichtungen für Haushaltsgeräte umfassen ein Gehäuse, eine das Gehäuse nach Außen abdeckende Schalterblende, eine in dem Gehäuse beabstandet zu der Schalterblende angeordnete Leiterplatte, mindestens eine berührungsempfindliche Bedieneinheit zur Bedienung des Haushaltsgeräts mit jeweils einer auf einer Außenseite der Schalterblende angeordneten Bedienfläche und mindestens einer auf der Leiterplatte angeordneten und der jeweiligen Bedienfläche zugeordneten Schaltelektronik, wobei die jeweils zueinander korrespondierende Bedienfläche und Schaltelektronik mittels eines Kopplungselements der jeweiligen Bedieneinheit miteinander elektrisch leitend verbunden sind, und mindestens eine auf der Leiterplatte angeordnete und der jeweiligen Bedienfläche funktional zugeordnete Lichtquelle zur bedarfsweisen Hinterleuchtung dieser Bedienfläche.

Der Erfindung stellt sich somit das Problem, eine Bedienvorrichtung für ein Haushaltsgerät und ein Haushaltsgerät mit einer Bedienvorrichtung zu verbessern.

Erfindungsgemäß wird dieses Problem durch eine Bedienvorrichtung für ein Haushaltsgerät mit den Merkmalen des Patentanspruchs 1 gelöst, die dadurch gekennzeichnet ist, dass das Kopplungselement gleichzeitig als ein Abschirmelement zur Abschirmung von mittels der Lichtquelle erzeugtem sichtbaren Licht ausgebildet und derart angeordnet ist, dass von der Lichtquelle emittiertes sichtbares Licht im Wesentlichen lediglich die Bedienfläche hinterleuchtet, der diese Lichtquelle zugeordnet ist. Vorteilhafterweise ist das gleichzeitig als Abschirmelement ausgebildete Kopplungselement derart ausgebildet und angeordnet, dass das von der Lichtquelle emittierte sichtbare Licht lediglich die Bedienfläche hinterleuchtet, der diese Lichtquelle zugeordnet ist. Die mindestens eine Lichtquelle kann dabei beispielsweise als mindestens eine LED ausgebildet sein. Zum Beispiel sind auch mehrfarbige LED-Lichtquellen denkbar, die bei lediglich geringem Platzbedarf eine mehrfarbige Hinterleuchtung der Bedienfläche ermöglichen. Ferner wird dieses Problem durch ein Haushaltsgerät mit den Merkmalen des Patentanspruchs 9 gelöst. Vorteilhafte Ausgestaltungen und Weiterbildungen der Erfindung ergeben sich aus den nachfolgenden Unteransprüchen.

Der mit der Erfindung erreichbare Vorteil besteht insbesondere darin, dass eine Bedienvorrichtung für ein Haushaltsgerät und ein Haushaltsgerät mit einer Bedienvorrichtung verbessert sind. Aufgrund der erfindungsgemäßen Ausbildung der Bedienvorrichtung für ein Haushaltsgerät und des Haushaltsgeräts mit einer Bedienvorrichtung ist eine qualitativ hochwertige hinterleuchtete berührungsempfindliche Bedienvorrichtung für ein Haushaltsgerät auf konstruktiv und fertigungstechnisch einfache Art und Weise realisierbar. Beispielsweise können Bauteile eingespart werden und es kann eine leitfähige Bedruckung auf einer der Leiterplatte zugewandten Innenseite der Schalterblende entfallen. Die Verwendung der erfindungsgemäßen Bedienvorrichtung ist dabei nicht auf Haushaltsgeräte wie beispielsweise Wäschebehandlungsmaschinen, Geschirrspüler und Küchengroßgeräte beschränkt. Die erfindungsgemäße Bedienvorrichtung ist auch bei derartigen Geräten für den professionellen Gebrauch, also für den gewerblichen Einsatz, vorteilhaft verwendbar.

Grundsätzlich ist die erfindungsgemäße Bedienvorrichtung für ein Haushaltsgerät nach Art, Funktionsweise, Material und Dimensionierung in weiten geeigneten Grenzen frei wählbar. Siehe hierzu auch die vorherigen Erläuterungen zu den verschiedenen Haushaltsgeräten.

Eine vorteilhafte Weiterbildung der erfindungsgemäßen Bedienvorrichtung für ein Haushaltsgerät sieht vor, dass das Kopplungselement gleichzeitig als ein Reflexionselement zur Reflexion von mittels der Lichtquelle erzeugten sichtbaren Licht ausgebildet ist. Auf diese Weise ist die Funktion der Lichtquelle, nämlich die Hinterleuchtung der Bedienfläche, weiter verbessert. Dies deshalb, weil ein geringerer Anteil des von der Lichtquelle emittierten Lichts von dem Kopplungselement absorbiert und ein weitaus größerer Anteil dieses Lichts im Ergebnis in Richtung der Bedienfläche reflektiert wird.

Eine weitere vorteilhafte Weiterbildung der erfindungsgemäßen Bedienvorrichtung für ein Haushaltsgerät sieht vor, dass das Kopplungselement als ein Spritzgussteil, bevorzugt als ein Kunststoffspritzgussteil, ausgebildet ist. Hierdurch ist die Herstellung der erfindungsgemäßen Bedienvorrichtung für ein Haushaltsgerät wesentlich vereinfacht und damit kostengünstiger ermöglicht. Dies gilt insbesondere für die bevorzugte Ausführungsform dieser Weiterbildung.

Eine andere vorteilhafte Weiterbildung der erfindungsgemäßen Bedienvorrichtung für ein Haushaltsgerät sieht vor, dass das Kopplungselement als ein elektrisch leitendes thermoplastisch verarbeitbares Elastomer ausgebildet ist. Zum einen ist thermoplastisch verarbeitbares Elastomer, kurz elektrisch leitendes TPE, für die Funktionalität des Kopplungselements sehr vorteilhaft. Zum anderen ist dieses Material sehr einfach handhabbar und verarbeitbar.

Eine weitere vorteilhafte Weiterbildung der erfindungsgemäßen Bedienvorrichtung für ein Haushaltsgerät sieht vor, dass das Kopplungselement nach Art eines Trichters ausgebildet ist, wobei sich ein von dem Kopplungselement mantelförmig umschlossener Innenraum ausgehend von der Leiterplatte mit der Lichtquelle in Richtung der Schalterblende erweitert. Auf diese Weise ist das Kopplungselement zum einen auf die beengten Platzverhältnisse auf der Leiterplatte und zum anderen auf die erforderliche zu hinterleuchtende Bedienfläche angepasst ausgebildet, ohne, dass es hierfür zusätzlicher Maßnahmen oder Bauteile bedarf.

Ferner sieht eine besonders vorteilhafte Weiterbildung der erfindungsgemäßen Bedienvorrichtung für ein Haushaltsgerät vor, dass das Kopplungselement gleichzeitig als ein Federelement zur federnden Anlage des Kopplungselements an der Schalterblende und/oder an der Leiterplatte ausgebildet ist. Hierdurch ist eine funktionssichere Anlage des Kopplungselements an der Schalterblende und/oder der Leiterplatte gewährleistet.

Eine vorteilhafte Weiterbildung der letztgenannten Ausführungsform der erfindungsgemäßen Bedienvorrichtung für ein Haushaltsgerät sieht vor, dass das Kopplungselement nach Art eines Faltenbalgs ausgebildet ist. Auf diese Weise ist die Ausbildung des Kopplungselements als Federelement auf konstruktiv und fertigungstechnisch besonders einfache Art realisierbar.

Eine andere vorteilhafte Weiterbildung der erfindungsgemäßen Bedienvorrichtung für ein Haushaltsgerät sieht vor, dass das Kopplungselement an dem Gehäuse fixiert, bevorzugt an das Gehäuse angespritzt, ist. Hierdurch ist eine funktionssichere Positionierung des Kopplungselements einerseits relativ zu der Bedienfläche der Schalterblende und andererseits relativ zu der Leiterplatte mit der darauf angeordneten Schaltelektronik und Lichtquelle auf einfache Art und Weise sichergestellt.

Ein Ausführungsbeispiel der Erfindung ist in den Zeichnungen rein schematisch dargestellt und wird nachfolgend näher beschrieben. Es zeigt
- Figur 1: ein Ausführungsbeispiel des erfindungsgemäßen Haushaltsgeräts mit der erfindungsgemäßen Bedienvorrichtung in einer Frontalansicht und
- Figur 2: die Bedienvorrichtung gemäß der Fig. 1 in einem Vertikalschnitt.

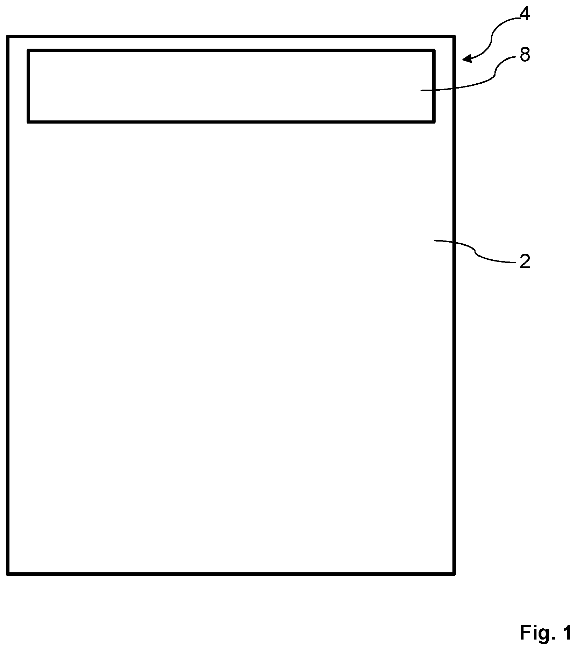

In der Fig. 1 ist ein Ausführungsbeispiel des erfindungsgemäßen Haushaltsgeräts mit der erfindungsgemäßen Bedienvorrichtung rein exemplarisch dargestellt.

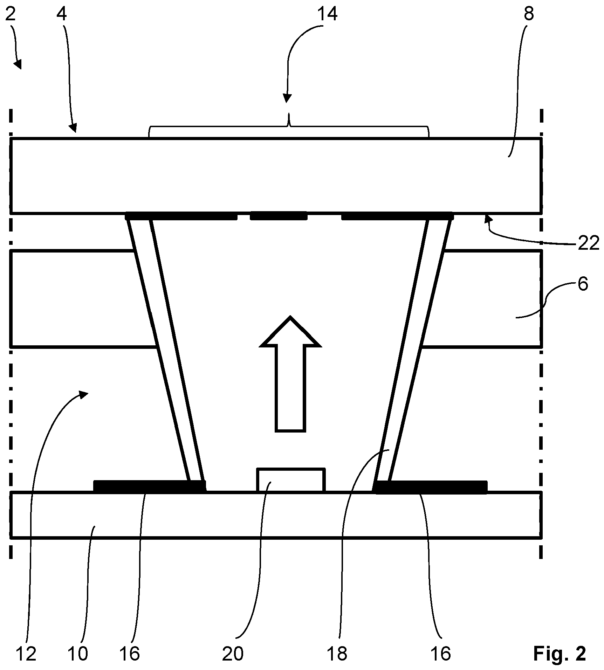

Das Haushaltsgerät 2 ist als eine Geschirrspülmaschine ausgebildet und weist unter anderem die Bedienvorrichtung 4 gemäß der Fig. 2 auf.

Die Bedienvorrichtung 4 umfasst ein Gehäuse 6, eine das Gehäuse 6 nach Außen abdeckende Schalterblende 8, eine in dem Gehäuse 6 beabstandet zu der Schalterblende 8 angeordnete Leiterplatte 10, mindestens eine berührungsempfindliche Bedieneinheit 12 zur Bedienung des Haushaltsgeräts 2 mit jeweils einer auf einer Außenseite der Schalterblende 8 angeordneten Bedienfläche 14 und mindestens einer auf der Leiterplatte 10 angeordneten und der jeweiligen Bedienfläche 14 zugeordneten Schaltelektronik 16, wobei die jeweils zueinander korrespondierende Bedienfläche 14 und Schaltelektronik 16 mittels eines Kopplungselements 18 der jeweiligen Bedieneinheit 12 miteinander elektrisch leitend verbunden sind, und mindestens eine auf der Leiterplatte 10 angeordnete und der jeweiligen Bedienfläche 14 funktional zugeordnete Lichtquelle 20 zur bedarfsweisen Hinterleuchtung dieser Bedienfläche 14.

Erfindungsgemäß ist das Kopplungselement 18 gleichzeitig als ein Abschirmelement zur Abschirmung von mittels der Lichtquelle 20 erzeugtem sichtbaren Licht ausgebildet und derart angeordnet, dass von der Lichtquelle 20 emittiertes sichtbares Licht im Wesentlichen lediglich die Bedienfläche 14 hinterleuchtet, der diese Lichtquelle 20 zugeordnet ist.

Die Lichtquelle 20 ist hier als mindestens eine LED, beispielsweise eine mehrfarbige LED-Lichtquelle ausgebildet. Die Schalterblende 8 ist auf einer der Leiterplatte 10 zugewandten Innenseite 22 derart bedruckt, dass zumindest bei mittels der Lichtquelle 20 hinterleuchteter Bedienfläche 14 in der Bedienfläche 14 ein Symbol oder dergleichen sichtbar ist.

Bei der vorliegenden Ausführungsform der erfindungsgemäßen Bedienvorrichtung ist das Kopplungselement 18 als ein Spritzgussteil, nämlich ein Kunststoffspritzgussteil, ausgebildet. Ferner ist das Kopplungselement 18 als ein elektrisch leitendes thermoplastisch verarbeitbares Elastomer ausgebildet, wobei das Kopplungselement 18 nach Art eines Trichters ausgebildet ist und sich ein von dem Kopplungselement 18 mantelförmig umschlossener Innenraum ausgehend von der Leiterplatte 10 mit der Lichtquelle 20 in Richtung der Schalterblende 8 erweitert.

Darüber hinaus ist das Kopplungselement 18 hier gleichzeitig als ein Federelement zur federnden Anlage des Kopplungselements 18 an der Schalterblende 8 ausgebildet. Zwecks federnder Anlage des Kopplungselements 18 an der Schalterblende 8 ist das Kopplungselement 18 bei dem vorliegenden Ausführungsbeispiel nach Art eines Faltenbalgs ausgebildet. Die Ausbildung des Kopplungselements 18 als Faltenbalg ist in der Fig. 2 nicht näher dargestellt.

Das Kopplungselement 18 ist an dem Gehäuse 6 fixiert, nämlich an dem Gehäuse 6 angespritzt.

Aufgrund der erfindungsgemäßen Ausbildung der Bedienvorrichtung 4 für ein Haushaltsgerät und des Haushaltsgeräts 2 ist eine qualitativ hochwertige hinterleuchtete berührungsempfindliche Bedienvorrichtung 4 für ein Haushaltsgerät 2 auf konstruktiv und fertigungstechnisch einfache Art und Weise realisierbar. Beispielsweise können Bauteile eingespart werden und es kann eine leitfähige Bedruckung auf der der Leiterplatte 10 zugewandten Innenseite 22 der Schalterblende 8, zur elektrisch leitenden Verbindung mit dem Kopplungselement 18, entfallen.

Die Erfindung ist nicht auf das vorliegende Ausführungsbeispiel beschränkt. Beispielsweise ist die Verwendung der erfindungsgemäßen Bedienvorrichtung auch bei als gewerbliche Geräte ausgebildeten Wäschebehandlungsmaschinen, Geschirrspülern und Küchengroßgeräten vorteilhaft einsetzbar. Siehe hierzu auch die diesbezüglichen Ausführungen in der Beschreibungseinleitung.

Ferner kann das Kopplungselement gleichzeitig als ein Reflexionselement zur Reflexion von mittels der Lichtquelle erzeugten sichtbaren Licht ausgebildet sein. Dabei kann zum Beispiel eine auf einer Innenseite des Kopplungselements angeordnete Reflexionsschicht derart ausgebildet sein, dass das von der Lichtquelle emittierte Licht im Ergebnis in Richtung der Bedienfläche geleitet wird.

## Patentansprüche

1. Bedienvorrichtung (4) für ein Haushaltsgerät (2), umfassend ein Gehäuse (6), eine das Gehäuse (6) nach Außen abdeckende Schalterblende (8), eine in dem Gehäuse (6) beabstandet zu der Schalterblende (8) angeordnete Leiterplatte (10), mindestens eine berührungsempfindliche Bedieneinheit (12) zur Bedienung des Haushaltsgeräts (2) mit jeweils einer auf einer Außenseite der Schalterblende (8) angeordneten Bedienfläche (14) und mindestens einer auf der Leiterplatte (10) angeordneten und der jeweiligen Bedienfläche (14) zugeordneten Schaltelektronik (16), wobei die jeweils zueinander korrespondierende Bedienfläche (14) und Schaltelektronik (16) mittels eines Kopplungselements (18) der jeweiligen Bedieneinheit (12) miteinander elektrisch leitend verbunden sind, und mindestens eine auf der Leiterplatte (10) angeordnete und der jeweiligen Bedienfläche (14) funktional zugeordnete Lichtquelle (20) zur bedarfsweisen Hinterleuchtung dieser Bedienfläche (14), **dadurch gekennzeichnet, dass** das Kopplungselement (18) gleichzeitig als ein Abschirmelement zur Abschirmung von mittels der Lichtquelle (20) erzeugtem sichtbaren Licht ausgebildet und derart angeordnet ist, dass von der Lichtquelle (20) emittiertes sichtbares Licht im Wesentlichen lediglich die Bedienfläche (14) hinterleuchtet, der diese Lichtquelle (20) zugeordnet ist.

2. Bedienvorrichtung nach Anspruch 1, **dadurch gekennzeichnet, dass** das Kopplungselement gleichzeitig als ein Reflexionselement zur Reflexion von mittels der Lichtquelle erzeugten sichtbaren Licht ausgebildet ist.

3. Bedienvorrichtung (4) nach Anspruch 1 oder 2, **dadurch gekennzeichnet, dass** das Kopplungselement (18) als ein Spritzgussteil, bevorzugt als ein Kunststoffspritzgussteil, ausgebildet ist.

4. Bedienvorrichtung (4) nach einem der Ansprüche 1 bis 3, **dadurch gekennzeichnet, dass** das Kopplungselement (18) als ein elektrisch leitendes thermoplastisch verarbeitbares Elastomer ausgebildet ist.

5. Bedienvorrichtung (4) nach einem der Ansprüche 1 bis 4, **dadurch gekennzeichnet, dass** das Kopplungselement (18) nach Art eines Trichters ausgebildet ist, wobei sich ein von dem Kopplungselement (18) mantelförmig umschlossener Innenraum ausgehend von der Leiterplatte (10) mit der Lichtquelle (20) in Richtung der Schalterblende (8) erweitert.

6. Bedienvorrichtung (4) nach einem der Ansprüche 1 bis 5, **dadurch gekennzeichnet, dass** das Kopplungselement (18) gleichzeitig als ein Federelement zur federnden Anlage des Kopplungselements (18) an der Schalterblende (8) und/oder an der Leiterplatte ausgebildet ist.

7. Bedienvorrichtung (4) nach Anspruch 6, **dadurch gekennzeichnet, dass** das Kopplungselement (18) nach Art eines Faltenbalgs ausgebildet ist.

8. Bedienvorrichtung (4) nach einem der Ansprüche 1 bis 7, **dadurch gekennzeichnet, dass** das Kopplungselement (18) an dem Gehäuse (6) fixiert, bevorzugt an das Gehäuse (6) angespritzt, ist.

9. Haushaltsgerät (2) mit einer Bedienvorrichtung (4), **dadurch gekennzeichnet, dass** die Bedienvorrichtung (4) nach einem der Ansprüche 1 bis 8 ausgebildet ist.
